# EUROPEAN PATENT APPLICATION

(11) **EP 4 567 551 A1**
(43) Date of publication of application: **11.06.2025**
(21) Application number: 23868337.9
(22) Date of filing: 11.07.2023
(51) Int. Cl.: G06F 1/16, H04M 1/02, F16C 11/04

(54) **ELECTRONIC DEVICE COMPRISING HINGE ASSEMBLY**

(30) Priority: 19.09.2022 KR 20220117768; 22.09.2022 KR 20220119849
(71) Applicant: Samsung Electronics Co., Ltd., Suwon-si, Gyeonggi-do 16677 (KR)
(72) Inventor: LEE, Sangchul, Suwon-si, Gyeonggi-do 16677 (KR)
(74) Representative: Appleyard Lees IP LLP
(86) International application number: PCT/KR2023/009824
(87) International publication number: WO 2024/063277

(57) **Abstract**

According to an embodiment of the present disclosure, an electronic device may comprise: first and second housings which are coupled pivotally about at least one folding axis between folded and unfolded states; a hinge assembly which pivotally connects the first and second housings to each other; a flexible display which includes a first display area disposed on one surface of the first housing, a second display area disposed on one surface of the second housing, and a folding area connecting the first and second display areas to each other and arranged to correspond to at least a part of the hinge assembly; and a hinge cover which is disposed between the first and second housings and is configured to be hidden or exposed according to pivoting of the second housing. **In** an embodiment, the hinge assembly may comprise: a first rotating plate which is rotated about a first rotational axis; and a second rotating plate which is rotatably connected to the first rotating plate and is rotated about a second rotational axis, wherein the first rotating plate supports at least a part of the folding area in the unfolded state, and a space in which the folding area is accommodated is provided in the folded state. Various other embodiments may also be possible.

## Description

### [Technical Field]

An embodiment of the disclosure relates to an electronic device, for example, an electronic device including a hinge assembly.

### [Background Art]

The term "electronic device" may refer to a device that performs a specific function based on an installed program, such as a home appliance, an electronic scheduler, a portable multimedia player, a mobile communication terminal, a tablet PC, a video/audio device, a desktop/laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be now equipped with various functions. For example, not only communication functions but also entertainment functions such as gaming, multimedia functions such as music and video playback, communication and security functions for mobile banking, or functions of schedule management or electronic wallet are being integrated into a single electronic device.

As the use of personal or portable communication devices, such as smartphones, has become common, user demands for portability and ease of use are increasing. For example, a touch screen display may provide a virtual keypad that replaces a mechanical input device (e.g., a button input device) while serving as an output device that outputs a screen (e.g., visual information). Accordingly, portable communication devices or electronic devices have come to be capable of providing the same or improved usability (e.g., a larger screen) while being miniaturized. On the other hand, with the commercialization of flexible, for example, foldable or rollable displays, it is expected that the portability and ease of use of electronic devices will be further improved. An electronic device including a flexible display may be carried in a state in which multiple different structures (e.g., housings) are folded or rolled and may provide a large screen in an unfolded state, thereby further improving portability and convenience of use.

None of the above contents make an assertion or decision as to whether any of the above might be applicable as prior art with regard to the disclosure.

### [Detailed Description of the Invention]

### [Technical Solution]

According to an embodiment of the disclosure, an electronic device may include a first housing, a second housing configured to rotate about one or more folding axes relative to the first housing between a position facing the first housing (hereinafter, "folded state") and a position unfolded by a predetermined angle from the folded state (hereinafter, "unfolded state"), a hinge assembly that is at least partially arranged between the first housing and the second housing and rotatably connects the first housing and the second housing, a flexible display including a first display area disposed on one surface of the first housing, a second display area disposed on one surface of the second housing, and a folding area that connects the first display area and the second display area and is disposed to correspond to at least a portion of the hinge assembly, and a hinge cover arranged between the first housing and the second housing and configured to be concealed or exposed between the other surface of the first housing and the other surface of the second housing as the second housing rotates. In an embodiment, the hinge assembly may include a hinge module disposed inside the hinge cover and configured to provide one or more folding axes, a first rotation plate rotatably coupled to the hinge module and configured to rotate about a first rotation axis, a second rotation plate rotatably coupled to the first rotation plate at a position spaced apart from the first rotation axis and configured to rotate about a second rotation axis, and a rotation support plate fixed to the first housing or the second housing. The rotation support plate supports the second rotation plate to be rotatably coupled at a position spaced apart from the second rotation axis and to rotate about a third rotation axis. In an embodiment, in the unfolded state, the first rotation plate may be configured to support at least a portion of the folding area by being supported by the hinge cover to be arranged to form a plane with the second rotation plate. In an embodiment, as the second housing rotates from the unfolded state to the folded state, the distance between the first rotation axis and the third rotation axis may be configured to decrease.

According to an embodiment of the disclosure, an electronic device may include a housing including a first housing and a second housing that are coupled to each other to be rotatable about one or more folding axes between a position facing each other (hereinafter, a "folded state") and a position unfolded by a predetermined angle (hereinafter, an "unfolded state"), a hinge assembly that is at least partially arranged between the first housing and the second housing and rotatably connects the first housing and the second housing, a flexible display including a first display area disposed on one surface of the first housing, a second display area disposed on one surface of the second housing, and a folding area that connects the first display area and the second display area and is disposed to correspond to at least a portion of the hinge assembly, and a hinge cover arranged between the first housing and the second housing and configured to be concealed or exposed between the other surface of the first housing and the other surface of the second housing as the second housing rotates. In an embodiment, the hinge assembly may include a hinge module disposed inside the hinge cover and configured to provide at least one folding axis, at least one first rotation plate rotatably coupled to the hinge module and configured to rotate about a first rotation axis, at least one second rotation plate rotatably coupled to the first rotation plate at a position spaced apart from the first rotation axis and configured to rotate about a second rotation axis, and a rotation support plate fixed to the first housing or the second housing. The rotation support plate supports the second rotation plate to be rotatably coupled at a position spaced apart from the second rotation axis and to rotate about a third rotation axis. In an embodiment, in the unfolded state, the first rotation plate may be configured to support at least a portion of the folding area by being supported by the hinge cover to be arranged to form a plane with the second rotation plate. In an embodiment, the first rotation plate and the second rotation plate may be configured to rotate relative to each other about the second rotation axis, so that in the folded state, the first and second rotation plates are arranged at an angle relative to each other and accommodated further inwardly into the first housing or the second housing than in the unfolded state.

### [Brief Description of Drawings]

The above and other aspects, features, and/or advantages of an embodiment of the disclosure will be more apparent from the following detailed description taken with reference to the accompanying drawings.
FIG. 1 is a view illustrating an unfolded state of an electronic device according to an embodiment of the disclosure.
FIG. 2 is a view illustrating an electronic device according to an embodiment of the disclosure in a folded state.
FIG. 3 is an exploded perspective view of the electronic device of FIG. 1 or FIG. 2 according to an embodiment of the disclosure.
FIG. 4 is an exploded perspective view illustrating an electronic device according to an embodiment of the disclosure.
FIG. 5 is an exploded perspective view illustrating a hinge assembly of an electronic device according to an embodiment of the disclosure.
FIG. 6 is a view illustrating the electronic device according to an embodiment of the disclosure in the folded state.
FIG. 7 is a view illustrating the electronic device according to an embodiment of the disclosure in the unfolded state.
FIG. 8 is a view illustrating a hinge assembly of an electronic device according to an embodiment of the disclosure.
FIGS. 9 to 12 are views sequentially illustrating the operation of an electronic device according to an embodiment of the disclosure.
FIG. 13 is an exploded perspective view illustrating a hinge assembly of an electronic device according to an embodiment of the disclosure.
FIG. 14 is a view illustrating the electronic device according to an embodiment of the disclosure in the folded state.
FIG. 15 is a view illustrating the electronic device according to an embodiment of the disclosure in the unfolded state.
FIG. 16 is a view illustrating the hinge assembly of the electronic device according to an embodiment of the disclosure.

Throughout the appended drawings, like reference numerals may be assigned to like components, configurations, and/or structures.

### [Mode for Carrying out the Invention]

In a structure where multiple different structures move relative to each other, for example, in an electronic device that is transformable between a folded state (or rolled state) and an unfolded state, efforts are being made to ensure the reliability of the electronic device. For example, the durability of the display may be ensured such that stable screen quality can be provided even after repeated transformation. In an electronic device having a structure that is transformed between the folded state and the unfolded state, when the display is folded into a state with an excessively large curvature (or a state with a small radius of curvature), a tensile or compressive force may be generated between the layers of the display. The tensile or compressive force generated as the display is transformed into a curved shape may vary in magnitude (or intensity) depending on each layer. For example, when a display is folded with an excessively large curvature, two layers that are bonded to each other may be peeled, or a layer subjected to a relatively large tensile force may undergo permanent deformation, leading to the formation of wrinkles on the display.

In describing the embodiment(s) of the disclosure, unless otherwise specified, the term "display" may refer to a flexible display that is at least partially transformable between a curved shape and a flat shape.

An embodiment of the disclosure may provide an electronic device including a hinge assembly, allowing the external appearance of the device to be transformed between a folded state and an unfolded state.

An embodiment of the disclosure may provide an electronic device including a hinge assembly capable of ensuring sufficient curvature radius of the display in a folded state while achieving miniaturization.

An embodiment of the disclosure may provide an electronic device including a hinge assembly capable of suppressing damage or deformation of the display by ensuring a sufficient curvature radius in the folded state of the display.

The technical subjects pursued in the disclosure may not be limited to the above-mentioned technical subjects, and other technical subjects which are not mentioned may be clearly understood from the following descriptions by those skilled in the art to which the disclosure pertains.

The following description made with reference to the accompanying drawings may provide an understanding of various exemplary implementations of the disclosure including the claims and equivalents thereof. An exemplary embodiment set forth in the following description includes various particular details to help the understanding, but is considered one of various exemplary embodiments. Therefore, it will be apparent to those skilled in the art that various changes and modifications may be made to various implementations described herein without departing from the scope and technical idea of the disclosure. In addition, descriptions of well-known functions and configurations may be omitted for clarity and brevity.

The terms and words used in the following description and claims are not limited to bibliographical meanings, but may be used to clearly and consistently describe the various embodiments set forth herein. Therefore, it will be apparent to those skilled in the art that the following description of various implementations of the disclosure is provided only for the purpose of explanation, rather than for the purpose of limiting the disclosure defined as the scope of protection and equivalents thereto.

It should be appreciated that a singular form such as "a," "an," or "the" also includes the meaning as a plural form, unless the context clearly indicates otherwise. Therefore, for example, "a component surface" may mean one or more of component surfaces.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

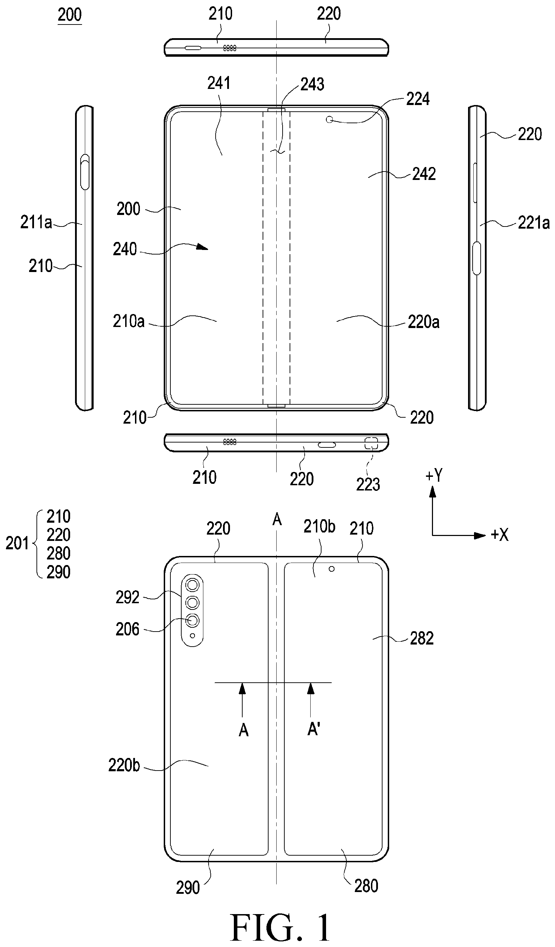

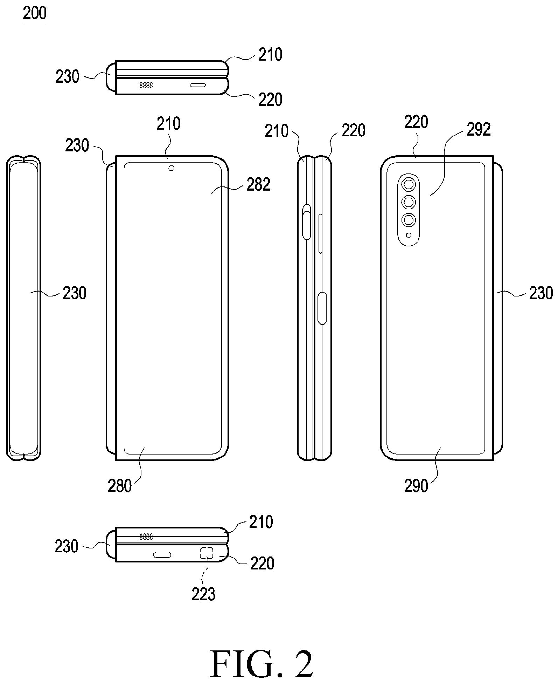

FIG. 1 is a view illustrating an unfolded state of an electronic device according to an embodiment of the disclosure. FIG. 2 is a view illustrating an electronic device according to an embodiment of the disclosure in a folded state.

Referring to FIGS. 1 and 2, in an embodiment, an electronic device 200 may include a housing 201, a hinge cover 230 configured to cover the foldable portion of the housing 201, and a flexible or foldable display 240 (hereinafter, simply referred to as a "display" 240) disposed in a space defined by the housing 201. According to an embodiment, the surface on which the display 240 is disposed is defined as the front surface (e.g., a first front surface 210a and a second front surface 220a) of the electronic device 200. The surface opposite to the front surface is defined as the rear surface (e.g., a first rear surface 210b and a second rear surface 220b) of the electronic device 200. In addition, a surface surrounding the space between the front and rear surfaces is defined as the side surface (e.g., a first side surface 211a and a second side surface 221a) of the electronic device 200.

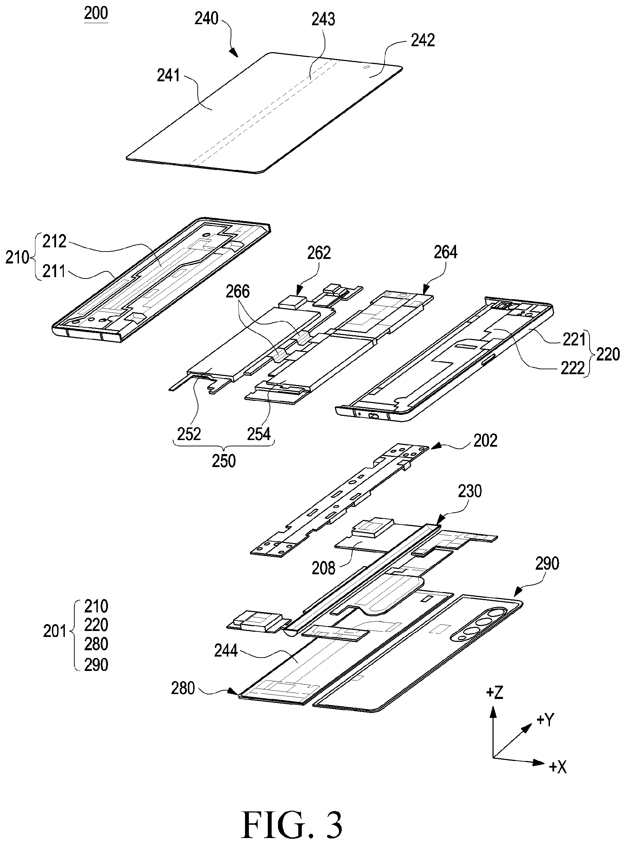

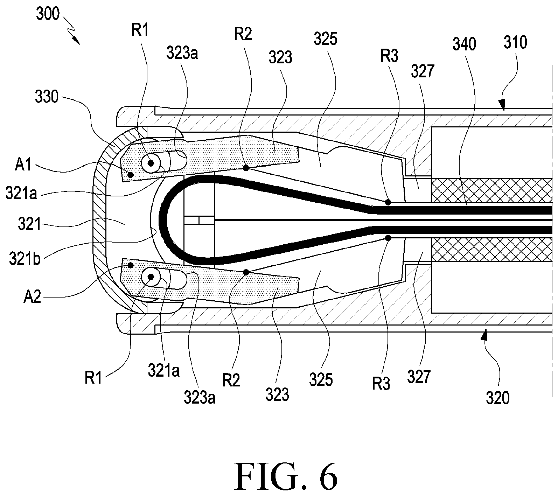

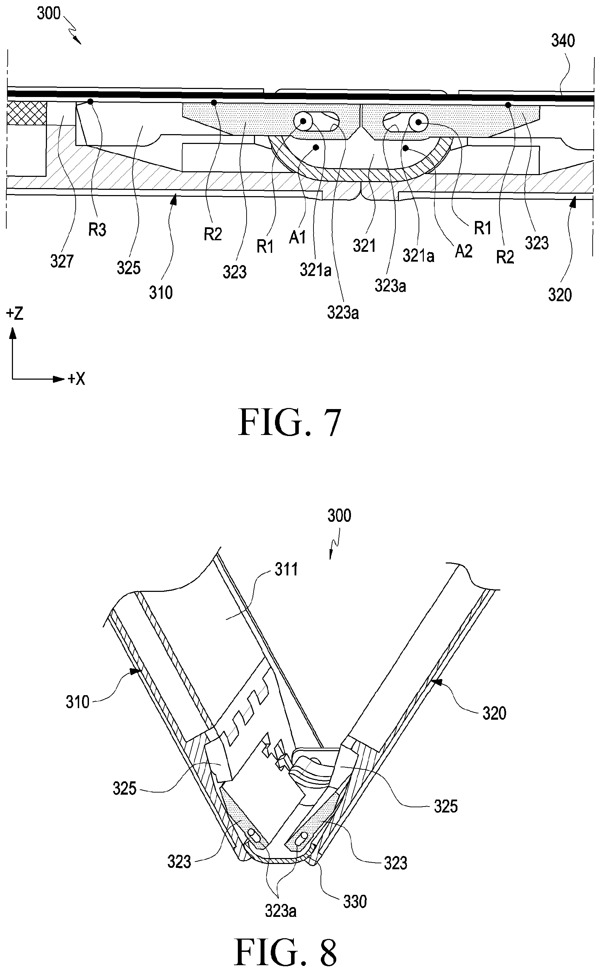

According to an embodiment, the housing 201 may include a first housing 210, a second housing 220 rotatably or pivotally coupled to the first housing 210, a first rear surface cover 280, a second rear surface cover 290, and a hinge module (e.g., the hinge module 202 in FIG. 3). The hinge module 202 may provide at least one folding axis A (e.g., the first and second folding axes A1 and A2 in FIG. 6 or FIG. 7 to be described below) that serves as a center of rotation of the first housing 210 and/or the second housing 220. The housing 201 of the electronic device 200 is not limited to the shape and assembly illustrated in FIGS. 2 and 3, but may be implemented by combinations and/or assemblies of other shapes or components. For example, in an embodiment, the first housing 210 and the first rear surface cover 280 may be integrated, and the second housing 220 and the second rear surface cover 290 may be integrated. According to an embodiment, the first housing 210 may include a first front surface 210a connected to a hinge module (e.g., the hinge module 202 in FIG. 3) and oriented in a first direction, and a first rear surface 210b oriented in a second direction opposite to the first direction. The second housing 220 may include a second front surface 220a connected to the hinge module 202 and oriented in a third direction, and a second rear surface 220b oriented in a fourth direction opposite to the third direction, and the second housing 220 may rotate relative to the first housing 210 about the hinge module 202. Accordingly, the electronic device 200 may be transformed to the folded state or the unfolded state. When the electronic device 200 is in the folded state, the first front surface 210a may face the second front surface 220a, and when the electronic device 101 is in the unfolded state, the third direction may be substantially parallel to the first direction. Hereinbelow, unless otherwise stated, directions will be described with reference to the state in which the electronic device 200 is unfolded.

According to an embodiment, the first housing 210 and the second housing 220 may be disposed on opposite sides about the folding axis A and may have generally symmetrical shapes with respect to the folding axis A. As will be described later, the angle or distance between the first housing 210 and the second housing 220 may vary depending on whether the electronic device 200 is in the unfolded state, in the folded state, or in the intermediate state. According to an embodiment, the second housing 220 may additionally include a sensor area 224 in which various sensors (e.g., a front camera) are arranged, unlike the first housing 210, but may have a shape symmetrical with the first housing 210 in other areas. According to an embodiment, there may be multiple (e.g., two) parallel folding axes A (e.g., the first folding axis A1 and the second folding axis A2 in FIG. 6 or FIG. 7 to be described below). In the disclosure, the folding axis A is provided along the longitudinal direction of the electronic device 200 (the Y-axis direction), but the direction of the folding axis A is not limited thereto. For example, depending on the external design or the user's use habits, the electronic device 200 may be understood to include a folding axis A extending along the width direction (e.g., the X-axis direction).

According to an embodiment, the electronic device 200 may include a structure into which a digital pen is insertable. For example, a hole 223 into which the digital pen is insertable may be provided in the side surface of the first housing 210 or the side surface of the second housing 220 of the electronic device 200.

According to an embodiment, the first housing 210 and the second housing 220 may be at least partially made of a metal or non-metal material having rigidity in a level selected in order to support the display 240. The at least a portion made of the metal material may provide a ground plane of the electronic device 200, and may be electrically connected to a ground conductor provided on a printed circuit board (e.g., the board unit 260 in FIG. 3).

According to an embodiment, the sensor area 224 may be provided to have a predetermined area adjacent to one corner of the second housing 220. However, the arrangement, shape, and size of the sensor area 224 are not limited to the illustrated example. For example, in other embodiments, the sensor area 224 may be provided at another corner or at any area between the upper and lower end corners in the second housing 220 or in the first housing 210. According to an embodiment, components built into the electronic device 200 to perform various functions may be visually exposed on the front surface of the electronic device 200 through the sensor area 224 or through one or more openings provided in the sensor area 224. In various embodiments, the components may include various types of sensors. The sensors may include, for example, at least one of a front camera, a receiver, or a proximity sensor.

According to an embodiments, the first rear surface cover 280 may be disposed on the rear surface of the electronic device 200 on one side of the folding axis A and may have, for example, a substantially rectangular periphery, which may be surrounded by the first housing 210. Similarly, the second rear surface cover 290 may be arranged on the other side of the folding axis A of the rear surface of the electronic device 200, and the periphery of the second rear surface cover 290 may be enclosed by the second housing 220.

According to an embodiment, the first rear surface cover 280 and the second rear surface cover 290 may have substantially symmetrical shapes about the folding axis A. However, the first rear surface cover 280 and the second rear surface cover 290 do not necessarily have mutually symmetrical shapes, and in another embodiment, the electronic device 200 may include a first rear surface cover 280 and a second rear surface cover 290 having various shapes.

According to an embodiment, the first rear surface cover 280, the second rear surface cover 290, the first housing 210, and the second housing 220 may define a space in which various components (e.g., a printed circuit board or a battery) of the electronic device 200 may be disposed. According to an embodiment, one or more components may be disposed or visually exposed on the rear surface of the electronic device 200. For example, at least a portion of the sub-display (e.g., the sub-display 244 in FIG. 3) may be visually exposed through the first rear surface area 282 of the first rear surface cover 280. In another embodiment, one or more components or sensors may be visually exposed through a second rear surface area 292 of the second rear surface cover 290. In various embodiments, the sensors may include a proximity sensor and/or a camera module 206 (e.g., a rear camera).

According to an embodiment, a front camera, which is visually exposed to the front surface of the electronic device 200 through one or more openings provided in the sensor area 224, or a camera module 206, which is visually exposed through the second rear surface area 292 of the second rear surface cover 290, may include one or more lenses, an image sensor, and/or an image signal processor. In some embodiments, two or more lenses (e.g., an infrared camera, a wide-angle lens, and a telephoto lens), and image sensors may be arranged on one surface of the electronic device 200.

Referring to FIG. 2, the hinge cover 230 may be disposed between the first housing 210 and the second housing 220 and may be configured to cover internal components (e.g., the hinge module 202 in FIG. 3). According to an embodiment, the hinge cover 230 may be covered by a portion of the first housing 210 and a portion of the second housing 220, or may be exposed to the outside depending on the state of the electronic device 200 (the unfolded state (flat stated) or the folded state). For example, in the unfolded state, the hinge cover 230 may be substantially covered by the first housing 210 and the second housing 220, and in the folded state, most of the outer surface of the hinge cover 230 may be exposed outside.

According to an embodiment, as illustrated in FIG. 1, when the electronic device 200 is in the unfolded state, the hinge cover 230 may not be exposed by being covered by the first housing 210 and the second housing 220. As another example, as illustrated in FIG. 2, when the electronic device 200 is in the folded state (e.g., the fully folded state), the hinge cover 230 may be exposed outside between the first housing 210 and the second housing 220. As another example, when the first housing 210 and the second housing 220 are in the intermediate state in which the first and second housings are folded with a certain angle therebetween, the hinge cover 230 may be partially exposed to the outside between the first housing 210 and the second housing 220. However, in this case, the exposed area may be smaller than that in the fully folded state. According to an embodiment, the hinge cover 230 may include a curved surface.

According to an embodiment, the display 240 may be placed in the space defined by the housing 201. For example, the display 240 may be seated in a recess defined by the housing 201, and may constitute most of the front surface of the electronic device 200. Accordingly, the front surface of the electronic device 200 may include the display 240, and partial areas of the first housing 210 and the second housing 220, which are adjacent to the display 240. In addition, the rear surface of the electronic device 200 may include the first rear surface cover 280, a partial area of the first housing 210 adjacent to the first rear surface cover 280, the second rear surface cover 290, and a partial area of the second housing 220 adjacent to the second rear surface cover 290.

According to an embodiment, the display 240 may refer to a display, at least a portion of which is transformable into a planar surface or a curved surface. According to an embodiment, the display 240 may include a folding area 243, a first display area 241 disposed on one side of the folding area 243 (e.g., the left side of the folding area 243 illustrated in FIG. 1), and a second display area 242 disposed on the other side of the folding area 243 (e.g., the right side of the folding area 203 illustrated in FIG. 1). The first display area 241 may refer to an area disposed on the first housing 210, and the second display area 242 may refer to an area disposed on the second housing 220. The folding area 243 may be partially disposed between the first housing 210 or the second housing 220, and may be transformed between a flat shape and a curved shape in response to the rotation of the first housing 210 or the second housing 220.

However, the area division of the display 240 is illustrative, and the display 240 may be divided into multiple areas (e.g., four or more areas or two areas) depending on the structure or functions thereof. For example, in the embodiment illustrated in FIG. 1, the area of the display 240 may be divided by the folding area 243 or the folding axis (the axis A) extending parallel to the Y axis. However, in another embodiment, the area of the display 240 may be divided based on another folding area (e.g., a folding area parallel to the X axis) or another folding axis (e.g., a folding axis parallel to the X axis). According to an embodiment, the display 240 may be coupled to or disposed adjacent to a touch-sensitive circuit, a pressure sensor that is capable of measuring touch intensity (pressure), and/or a digitizer (not illustrated) configured to detect a magnetic field-type stylus pen.

According to an embodiment, the first display area 241 and the second display area 242 may have generally symmetrical shapes about the folding area 243. According to an embodiment (not illustrated), unlike the first display area 241, the second display area 242 may include a notch cut due to the presence of the sensor area 224, but may have a shape symmetrical to the first display area 241 in areas other than the sensor area. In other words, the first display area 241 and the second display area 242 may include portions having mutually symmetrical shapes and portions having mutually asymmetrical shapes.

Hereinafter, the operations of the first housing 210 and the second housing 220 depending on the states of the electronic device 200 (e.g., a flat or unfolded state and a folded state) and respective areas of the display 240 will be described.

According to an embodiment, when the electronic device 200 is in the unfolded state (flat state) (e.g., FIG. 1), the first housing 210 and the second housing 220 may be disposed to form a substantially 180-degree angle, and the first display area 241 and the second display area 242 may be disposed to be oriented in substantially the same direction. For example, in the unfolded state, the surface of the first display area 241 and the surface of the second display area 242 may form 180 degrees therebetween and may be oriented in the same direction (e.g., in the forward direction of the electronic device). The folding area 243 may define the same plane as the first display area 241 and the second display area 242.

According to an embodiment, when the electronic device 200 is in the folded state (e.g., FIG. 2), the first housing 210 and the second housing 220 may be disposed to face each other. The surface of the first display area 241 and the surface of the second display area 242 of the display 240 may substantially face each other while forming a narrow angle (e.g., between 0 degrees and 10 degrees) therebetween. At least a portion of the folding area 243 may be transformed into a curved shape with a predetermined curvature.

According to an embodiment, when the electronic device 200 is in the intermediate state (folded state) (e.g., FIG. 3), the first housing 210 and the second housing 220 may be disposed to form a certain angle relative to each other. The surface of the first display area 241 and the surface of the second display area 242 of the display 240 may form an angle greater than that in the folded state and smaller than that in the unfolded state. At least a portion of the folding area 243 may form a curved surface having a predetermined curvature, and the curvature in this case may be smaller than that in the folded state.

FIG. 3 is an exploded perspective view of the electronic device of FIG. 1 or 2 according to an embodiment of the disclosure.

Referring to FIG. 3, the electronic device 200 may include a housing 201, a display 240, a hinge module 202, a battery 250, and a board unit 260. The housing 201 may include a first housing 210, a second housing 220, a first rear surface cover 280, and a second rear surface cover 290.

According to an embodiment, the housing 201 may include a first housing 210, a second housing 220, a hinge cover 230, a first rear surface cover 280, and a second rear surface cover 290. The configuration of the first housing 210, the second housing 220, the hinge cover 230, the first rear surface cover 280, and the second rear surface cover 290 in FIG. 3 may be wholly or partly the same as the configuration of the first housing 210, the second housing 220, the hinge cover 230, the first rear surface cover 280, and the second rear surface cover 290 in FIG. 1 and/or FIG. 2. In an embodiment, a hinge module 202 is arranged inside the housing 201 to rotatably connect the first housing 210 and the second housing 220.

According to an embodiment, the first housing 210 and the second housing 220 may be assembled to each other to be coupled to opposite sides of the hinge module 202. According to an embodiment, the first housing 210 may include a first support area 212 (e.g., the first support plate or first support member) capable of supporting components (e.g., the first circuit board 262 and/or the first battery 252) of the electronic device 200 and a first side wall 211 surrounding at least a portion of the first support area 212. The first side wall 211 may include a first side surface (e.g., the first side surface 211a in FIG. 2) of the electronic device 200. According to an embodiment, the second housing 220 may include a second support area 222 (e.g., the second support plate or the second support member) capable of supporting components (e.g., the second circuit board 264 and/or the second battery 254) of the electronic device 200 and a second side wall 221 surrounding at least a portion of the second support area 222. The second side wall 221 may include a second side surface (e.g., the second side surface 221a in FIG. 2) of the electronic device 200.

According to an embodiment, the display 240 may include a first display area 241, a second display area 242, a folding area 243, and a sub-display 244. The configuration of the first display area 241, the second display area 242, and the folding area 243 in FIG. 3 may be wholly or partly the same as or similar to the configuration of the first display area 241, the second display area 242, and the folding area 243 in FIG. 1 and/or FIG. 2.

According to an embodiment, the sub-display 244 may display a screen in a different direction from the display areas 241 and 242. For example, the sub-display 244 may output a screen in a direction opposite to the first display area 241. According to an embodiment, the sub-display 244 may be disposed on the first rear surface cover 280.

According to an embodiment, the battery 250 may include a first battery 252 disposed in the first housing 210 and a second battery 254 disposed in the second housing 220. According to an embodiment, the first battery 252 may be disposed on the first circuit board 262, and the second battery 254 may be disposed on the second circuit board 264.

According to an embodiment, the board unit 260 may include the first circuit board 262 disposed within the first housing 210 and the second circuit board 264 disposed within the second housing 220. According to an embodiment, the board unit 260 may include at least one flexible printed circuit board 266 for electrically connecting the first circuit board 262 and the second circuit board 264. According to an embodiment, at least a portion of flexible printed circuit board 266 may be disposed across the hinge module 202. According to an embodiment, the first circuit board 262 and the second circuit board 264 may be disposed inside a space defined by the first housing 210, the second housing 220, the first rear surface cover 280, and the second rear surface cover 290. Components for implementing various functions of the electronic device 200 may be mounted on the first circuit board 262 and the second circuit board 264.

According to an embodiment, the electronic device 200 may include a speaker module 208. According to an embodiment, the speaker module 208 may convert an electrical signal into sound. According to an embodiment, the speaker module 208 may be disposed inside the space defined by the first housing 210, the second housing 220, the first rear surface cover 280, and the second rear surface cover 290.

The following detailed description may exemplify a configuration in which the first housing 210 and the second housing 220 are rotatably connected or coupled by a hinge module (or hinge assembly). However, it should be noted that these embodiments do not limit an electronic device according to the embodiment(s) of the disclosure. For example, an electronic device according to the embodiment(s) disclosed herein may include three or more housings, and the "a pair of housings" in the embodiment(s) disclosed below may mean "two housings rotatably coupled to each other among three or more housings". In an embodiment, at least one of the first housing 210 and the second housing 220 may be slidably coupled with a third housing(s) (not illustrated), and the visually exposed area of the display may be expanded or reduced in response to the sliding of the third housing(s). In the following detailed description, a detailed description of a configuration readily understood through the preceding embodiments may be omitted, and the electronic device 200 of the preceding embodiments may be further referenced as needed.

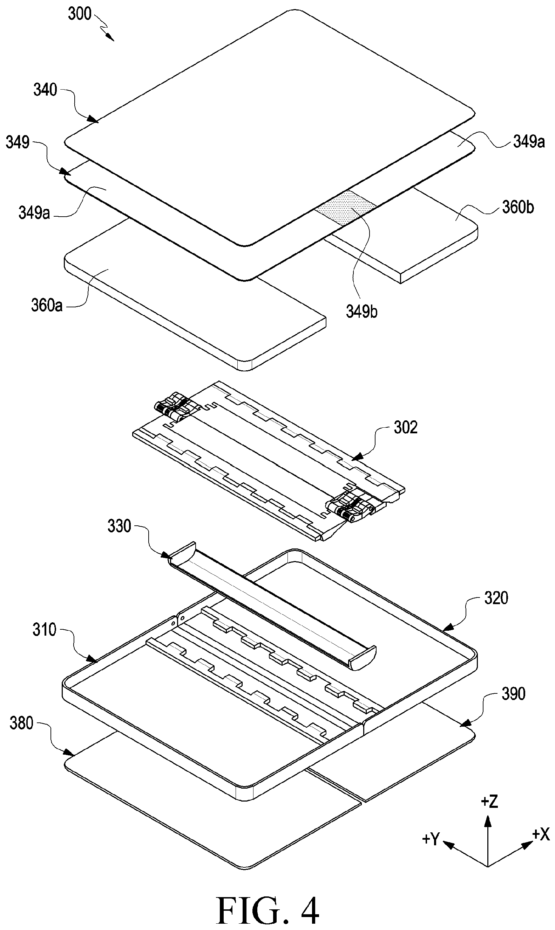

FIG. 4 is an exploded perspective view illustrating an electronic device according to an embodiment of the disclosure.

Referring to FIG. 4, an electronic device 300 may include a first housing 310 (e.g., the first housing 210 in FIGS. 1 to 3), a second housing 320 (e.g., the second housing 220 in FIGS. 1 to 3), a hinge cover 330 (e.g., the hinge cover 230 in FIG. 2 or FIG. 3), a hinge assembly 302 (e.g., the hinge module 202 in FIG. 3), and/or a flexible display 340 (e.g., the display 240 in FIG. 1 or FIG. 3). In an embodiment, one or more electrical components 360a and 360b may be arranged inside the first housing 310 and/or the second housing 320. The electrical components 360a and 360b may each include, for example, the battery 250 or the board unit 260 in FIG. 3. Depending on the internal structure of the electronic device 300, the arrangement or shapes of the electrical components 360a and 360b may be variously changed. In an embodiment, the electronic device 300 may further include one or more rear surface covers 380 and 390 coupled to the first housing 310 or the second housing 320. In an embodiment, the one or more rear covers 380 and 390 may function as a window that protects the sub-display (e.g., the sub-display 244 in FIG. 3).

According to an embodiment, the electronic device 300 may further include a support sheet 349 that supports the display 340. The support sheet 349 may include one or more flat areas 349a corresponding to a first display area (e.g., the first display area 241 in FIG. 3) or a second display area (e.g., the second display area 242 in FIG. 3) of the display 340, and a flexible area 349b arranged between the flat areas 349a. For example, the flat areas 349a may be disposed to correspond to the first display area 241 or the second display area 242, and the flexible area 349b may be disposed to correspond to the folding area (e.g., the folding area 243 in FIG. 3). The flat areas 349a may substantially maintain a flat shape, and the flexible area 349b may be transformed in response to the rotation of the first housing 310 or the second housing 320. For example, the flexible area 349b may have a lower elastic modulus than the flat areas 349a. However, the embodiment(s) of the disclosure are not limited thereto, and the flat areas 349a may be disposed or coupled to the first housing 310 or the second housing 320 while having substantially the same elastic modulus as the flexible area 349b to be maintained in a flat shape. In an embodiment, the support sheet 349 may function as an adhesive member that couples the display 340 to the first housing 310 or the second housing 320. In an embodiment, the support sheet 349 may function as a protective member that protects the display 340 from the mechanical structure of the first housing 310 or the second housing 320.

According to an embodiment, the hinge cover 330 may be disposed in an area between the first housing 310 and the second housing 320 or between the rear covers 380 and 390, on the surface opposite to the display 340. In an embodiment, the "area between the first housing 310 and the second housing 320", or the "area between the rear surface covers 380 and 390" may be understood as an area that at least partially corresponds to the folding area 243 of FIG. 1 or FIG. 3. In an embodiment, the hinge cover 330 may be substantially accommodated inside the first housing 310 or the second housing 320 in the unfolded state, and may be at least partially visually exposed to the external space in the folded state. For example, the gap between the rear surface covers 380 and 390 may change in response to the rotation of the first housing 310 or the second housing 320, and the hinge cover 330 may be concealed or exposed between the other surface of the first housing 310 and the other surface of the second housing 320 (e.g., between the rear surface covers 380 and 390).

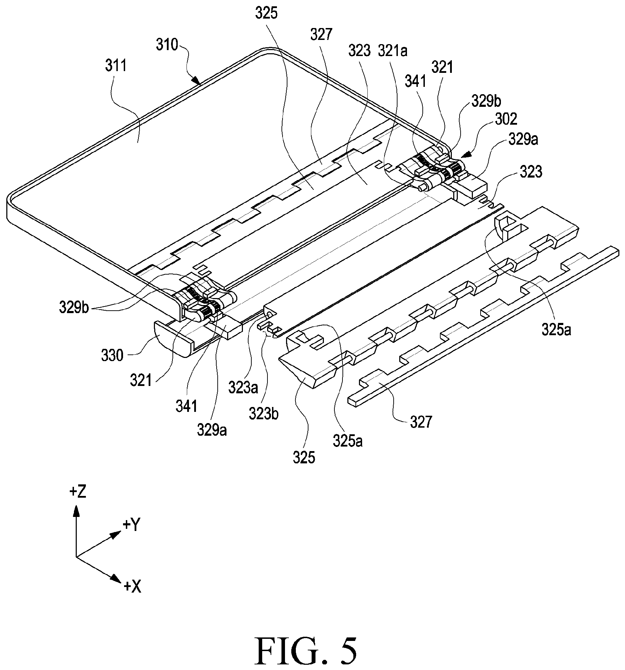

According to an embodiment, the hinge assembly 302 may be disposed at least partially inside the hinge cover 330 (e.g., between the first housing 310 and the second housing 320) and may rotatably connect the first housing 310 and the second housing 320. As will be described later, the hinge assembly 302 may include multiple rotation plates (e.g., the first rotation plates 323 and the second rotation plates 325 in FIG. 5 to be described later). The multiple rotation plates may be arranged in a flat shape in the unfolded state to support at least a portion of the folding area 243, and may be arranged at an angle relative to each other in the folded state to provide a space that accommodates at least a portion of the folding area 243 transformed into a curved shape.

FIG. 5 is an exploded perspective view illustrating a hinge assembly of an electronic device according to an embodiment of the disclosure. FIG. 6 is a view illustrating the electronic device according to an embodiment of the disclosure in the folded state. FIG. 7 is a view illustrating the electronic device according to an embodiment of the disclosure in the unfolded state. FIG. 8 is a view illustrating a hinge assembly of an electronic device according to an embodiment of the disclosure.

Referring to FIGS. 5 to 8, a hinge assembly 302 may include a hinge module 321, a first rotation plate 323, a second rotation plate 325, and/or a rotation support plate 327. According to an embodiment, the rotation support plate 327 may be understood as a portion of the first housing 310 or the second housing 320. As illustrated in FIG. 6, in the folded state, the first rotation plate 323 and the second rotation plate 325 may be arranged at an angle relative to each other, thereby at least partially accommodating the folding area 243 transformed into a curved shape. For example, in the folded state, the first rotation plate 323 and the second rotation plate 325 may be arranged at an angle relative to each other, allowing them to be accommodated further inward within the first housing 310 or the second housing 320 than in the unfolded state, thereby expanding the space for accommodating the folding area 243. As illustrated in FIG. 7, in the unfolded state, the first rotation plate 323 and the second rotation plate 325 may be arranged to form a plane, allowing them to support at least a portion of the folding area 243. For example, even when an external force, such as a user's touch input, is applied to the folding area 243 in the use state (e.g., in the unfolded state), the first rotation plate 323 and the second rotation plate 325 may suppress deformation of the folding area 243. In an embodiment, since the folding area 243 is supported by the first rotation plate 323 and the second rotation plate 325 in the unfolded state, the user may tactilely perceive a touch input (or a pressure according to the touch) in the folding area 243.

According to an embodiment, there may be a difference in the gap or distance between the hinge module 321 and the rotation support plate 327 depending on the folded state and the unfolded state. In an embodiment, in response to the change in this gap or distance, the first rotation plate 323 and the second rotation plate 325 may be rotated to be arranged at an angle relative to each other or to form a plane. In an embodiment, the "gap between the hinge module 321 and the rotation support plate 327" may be understood as the gap between a first rotation axis R1 (described below) and the rotation support plate 327, or the gap between a first rotation axis R1 and a third rotation axis R3 (described below). The change in the gap or distance between the hinge module 321 and the rotation support plate 327 will be described again below.

According to an embodiment, the hinge module 321 may be substantially disposed inside the hinge cover 330 and may provide at least one folding axis A1 or A2 (e.g., the folding axis A in FIG. 1). For example, the first housing 310 may be coupled to the hinge module 321 and may rotate or pivot about the first folding axis A1 of the at least one folding axis, and the second housing 320 may be coupled to the hinge module 321 and may rotate or pivot about the second folding axis A2 of the at least one folding axis. According to an embodiment, the hinge module 321 may include one or more hinge arms 329a arranged to be rotatable about the first folding axis A1 or the second folding axis A2. For example, one of the hinge arms 329a (hereinafter, a "first hinge arm") may be rotated about the first folding axis A1 and may be mounted on the first housing 310, allowing the first housing 310 to be coupled to the hinge module 321 and to rotate or pivot about the first folding axis A1. Another one of the hinge arms 329a (hereinafter, a "second hinge arm") may be rotated about the second folding axis A2 and may be mounted on the second housing 320, allowing the second housing 320 to be coupled to the hinge module 321 and to rotate or pivot about the second folding axis A2. In FIG. 6, the first hinge arms may be substantially covered by the second rotation plates 325, and the hinge arm indicated by reference numeral "329a" may be an example of the second hinge arm mounted on the second housing 320.

In an embodiment, the hinge module 321 may further include multiple gears 341. For example, the hinge module 321 may include a gear aligned on the first folding axis A1 and a gear aligned on the second folding axis A2. In an embodiment, the multiple gears 341 may be configured to mesh to rotate the hinge arms 329a (and/or the first housing 310 and the second housing 320) in the opposite directions relative to each other. For example, in FIG. 6, when the first housing 310 rotates counterclockwise, the second housing 320 may rotate in the opposite direction (e.g., clockwise) to the first housing 310 by the multiple gears 341. In an embodiment, the multiple gears 341 may be formed in one pair, two pairs, and/or three pairs. For example, the number of gears 341 may be selected depending on the distance between the first folding axis A1 and the second folding axis A2, or the diameter of each gear 341. In terms of the number and arrangement of these gears 341, a structure that rotates the hinge arms 329a in the opposite directions to each other may be considered.

According to an embodiment, the hinge module 321 may further include a curved area 321b. For example, the curved area 321b may be arranged to face the display 340 (e.g., the folding area 243) when the hinge module 321 is arranged on the hinge cover 330, and may have a concave shape. For example, in the folded state, the curved area 321b may form or define a space that accommodates at least a portion of the folding area 243 that has been transformed into a curved shape. Accordingly, the curved area 321b may provide a space capable of accommodating the folding area 243, thereby suppressing or alleviating an increase in the curvature of the folding area 243 in the folded state.

According to an embodiment, the hinge module 321 may further include one or more support protrusions 329b that protrude and retract on the curved area 321b. The support protrusions 329b may be provided, for example, on the hinge arms 329a to pivot (e.g., orbit) about the first folding axis A1 or the second folding axis A2. For example, the one or more support protrusions 329b may protrude to the exterior of the curved area 321b of the hinge module 321 in the unfolded state, and may be accommodated into the interior of the hinge module 321 in the folded state. Accordingly, in the unfolded state, the one or more support protrusions 329b function as a structure that supports a portion of the folding area 243 in the space provided by the curved area 321b, and in the folded state, the support protrusions 329b are accommodated into the interior of the hinge module 321, allowing the space provided by the curved area 321b to accommodate a portion of the folding area 243.

According to an embodiment, the first rotation plate 323, the second rotation plate 325, and/or the rotation support plate 327 may be provided to correspond to each of the first housing 310 and the second housing 320. For example, a single hinge assembly 302 may include a single pair (or two pairs) of the first rotation plates 323, a pair (or two pairs) of the second rotation plates 325, and/or a single pair (or two pairs) of the rotation support plates 327. In an embodiment, the rotation axes of the first rotation plate 323 or the second rotation plate 325 corresponding to the first housing 310 may be arranged at different positions from the rotation axes of the first rotation plate 323 or the second rotation plate 325 corresponding to the second housing 320, but may be arranged symmetrically to each other. For example, the structure corresponding to the second housing 320 may be easily understood through the detailed description of the first rotation plate 323 or the second rotation plate 325 corresponding to the first housing 310. Therefore, in the following, for the sake of conciseness of description, the first rotation plate 323, the second rotation plate 325, and/or the rotation support plate 327 may be described by way of an example based on a configuration corresponding to either the first housing 310 or the second housing 320.

According to an embodiment, the first rotation plate 323 may be rotatably coupled to the hinge module 321 to rotate about the first rotation axis R1. The first rotation axis R1 may be understood as, for example, an axis that is spaced apart from the first folding axis A1 (or the second folding axis A2) and is parallel to the first folding axis A1. In an embodiment, multiple (e.g., a pair of) hinge modules 321 may be provided, and the first rotation plate 323 may be rotatably arranged between two hinge modules 321 selected among the multiple hinge modules 321.

According to an embodiment, the hinge assembly 302 and/or the hinge module 321 may include a guide protrusion 321a extending from a position spaced apart from a folding axis (e.g., the first folding axis A1 or the second folding axis A2) along the folding axis direction. For example, the first rotation plate 323 may be coupled to the guide protrusion 321a, and may rotate relative to the hinge module 321 about the first rotation axis R1 provided by the guide protrusion 321a. In an embodiment, the hinge assembly 302 and/or the hinge module 321 may further include a guide groove 323a (or guide hole) formed on a side surface of the first rotation plate 323. The guide groove 323a may accommodate, for example, the guide protrusion 321a of the hinge module 321. For example, when the guide protrusion 321a is accommodated in the guide groove 323a, the first rotation plate 323 may be coupled with the hinge module 321 to be rotatable about the first rotation axis R1.

According to an embodiment, the guide groove 323a may extend in a direction intersecting the first folding axis A1 or the first rotation axis R1. For example, the first rotation plate 323 may slide relative to the guide protrusion 321a under the guidance of the guide groove 323a while rotating about the first rotation axis R1 relative to the hinge module 321. As mentioned above, the gap between the hinge module 321 and the rotation support plate 327 (e.g., the gap between the first rotation axis R1 and the third rotation axis R3) may be changed in response to the rotation of the first housing 310 or the second housing 320, and the sliding of the first rotation plate 323 relative to the guide protrusion 321a (and/or the rotation of the first rotation plate 323 and the second rotation plate 325 relative to each other) may allow the gap between the hinge module 321 and the rotation support plate 327 to be changed. In an embodiment, the guide groove 323a may be shaped to accommodate and fix the guide protrusion 321a. For example, when the guide groove 323a does not extend in a direction intersecting the first rotation axis R1 and accommodates or fixes the guide protrusion 321a, the first rotation plate 323 may be coupled to the guide protrusion 321a and rotate about the first rotation axis R1, and the slide movement may be limited. The shape of the guide groove 323a (e.g., the length extending in the direction intersecting the first rotation axis R1) may vary depending on the gap between the first folding axis A1 and the first rotation axis R1, the angle of inclination between the first rotation plate 323 and the second rotation plate 325 in the folded state, and/or the degree of change in the gap between the hinge module 321 and the rotation support plate 327.

According to an embodiment, in the unfolded state, the first rotation plate 323 may be supported by the hinge cover 330. For example, in the unfolded state in which the first housing 310 and the second housing 320 forms an angle of about 180 degrees, the first rotation plate 323 may be supported by the hinge cover 330 to maintain a stationary state. In an embodiment, in the unfolded state, the first rotation plate 323 may be supported on the hinge cover 330 in the state in which the guide protrusion 321a is accommodated in the guide groove 323a, thereby allowing the first rotation plate 323 to maintain the stationary state without rotating any more in the unfolded direction. According to an embodiment, as long as the first housing 310 or the second housing 320 does not rotate in the folding direction while being unfolded to form an angle of about 180 degrees, the first rotation plate 323 may maintain a flat state with the second rotation plate 325 by being supported by the guide protrusion 321a, the guide groove 323a, and/or the hinge cover 330.

According to an embodiment, the second rotation plate 325 may be coupled to the first rotation plate 323 at a position spaced apart from the first rotation axis R1 and may rotate about the second rotation axis R1. The second rotation axis R1 may be understood as, for example, the first folding axis A1 (or the second folding axis A2) and/or an axis spaced apart from the first rotation axis R1 and parallel to the first folding axis A1. In implementing the second rotation axis R2, the hinge assembly 302 may include a guide rail 325a provided on one of the first rotation plate 323 and the second rotation plate 325, and a rail groove 323b provided on the other of the first rotation plate 323 and the second rotation plate 325. In the illustrated embodiment, the guide rail 325a may protrude from the second rotation plate 325 in the second rotation axis R2 direction, and the rail groove 323b may be recessed in the first rotation plate 323 along the second rotation axis R2 direction. In an embodiment, the guide rail 325a and the rail groove 323b may extend along an arc trajectory centered on the second rotation axis R2.

According to an embodiment, the guide rail 325a may be accommodated in the rail groove 323b to move along the arc trajectory, thereby guiding the rotation of the first rotation plate 323 and/or the second rotation plate 325 centered on the second rotation axis R2. For example, the first rotation plate 323 and the second rotation plate 325 may be coupled to be rotatable about the second rotation axis R2 by the structure of the guide rail 325a and/or the rail groove 323b. Since the guide rail 325a and/or the rail groove 323b may have the arc trajectory centered on the second rotation axis R2, the movement of the first rotation plate 323 and the second rotation plate 325 relative to each other in a direction parallel to the second rotation axis R2 or a direction intersecting the second rotation axis R2 may be suppressed.

In an embodiment, in the unfolded state, since the first rotation plate 323 is supported by the guide protrusion 321a, the guide groove 323a, and/or the hinge cover 330, the second rotation plate 325 may be maintained in a flat state with the first rotation plate 323, as long as the first housing 310 or the second housing 320 does not rotate toward the folded state. For example, the support structure of the first rotation plate 323 by the guide protrusion 321a, the guide groove 323a, and/or the hinge cover 330 and the rail structure between the first rotation plate 323 and the second rotation plate 325 may be combined to stably support the folding area 243 in the unfolded state. In the unfolded state, an area that is not supported by the first rotation plate 323 and/or the second rotation plate 325, for example, an area facing the hinge module 321 in the folding area 243, may be supported by the one or more support protrusions 329b protruding into the curved area 321b. For example, when the folding area 243 has a flat shape, the hinge assembly 302 (e.g., the first rotation plate 323, the second rotation plate 325, and/or the one or more support protrusions 329b) may stably support the folding area 243 and provide an environment in which the user may perceive a touch pressure in a touch input.

According to an embodiment, the rotation support plate 327 may be fixed to either the first housing 310 or the second housing 320, and the second rotation plate 325 may be rotatably coupled to the rotation support plate 327 at a position spaced apart from the second rotation axis R2. For example, the second rotation plate 325 may rotate relative to the rotation support plate 327 about a third rotation axis R3 different from the second rotation axis R2 while being supported by the rotation support plate 327. The third rotation axis R3 may be understood as, for example, a folding axis (e.g., the folding axis A in FIG. 1 or the first folding axis A1 and the second folding axis A2 in FIG. 6), an axis spaced apart from the first rotation axis R1 and/or the second rotation axis R2 and parallel to the first folding axis A1. Although not illustrated, similar to the structure of the guide protrusion 321a and the guide groove 323a, a combination of a protrusion and a groove or a combination of a rod and a hole may be used to rotatably couple the second rotation plate 325 and the rotation support plate 327. In an embodiment, the rotation support plate 327 may be provided as a portion of the first housing 310 or the second housing 320. For example, the rotation support plate 327 may be implemented as a portion of the first support area 212 or the second support area 222 of FIG. 3. For example, the rotation support plate 327 may be provided integrally in the support area 311 of the first housing 310 (or the second housing 320). For example, in the embodiment(s) of the disclosure, although the first rotation plate 323, the second rotation plate 325, and/or the rotation support plate 327 are described as being included in the hinge assembly 302, it should be noted that this is for convenience of description and that the present disclosure is not limited thereto.

According to an embodiment, as illustrated in FIGS. 6 and 7, the first rotation axis R1 may be fixed relative to the first folding axis A1, and the second rotation axis R2 and/or the third rotation axis R3 may rotate about the first folding axis A1. Referring to the unfolded state of FIG. 7, it may be seen that the first folding axis A1, the first rotation axis R1, and the third rotation axis R3 may be arranged at different heights in the Z-axis direction, and the gap (or distance) between the first folding axis A1 and the third rotation axis R3 is substantially the same as the gap between the first rotation axis R1 and the third rotation axis R3. Compared to the unfolded state of FIG. 7, it may be seen that, in the folded state of FIG. 6, the first rotation axis R1 is located substantially between the first folding axis A1 and the third rotation axis R3. For example, as the first housing 310 or the second housing 320 rotates from the unfolded state to the folded state, the distance between the first rotation axis R1 and the third rotation axis R3 may gradually decrease. In response to the change in the distance between the first rotation axis R1 and the third rotation axis R3, the first rotation plate 323 may slide relative to the guide protrusion 321a, or the first rotation plate 323 and the second rotation plate 325 may rotate relative to each other (e.g., about the second rotation axis R2). In an embodiment, similar to the change in distance between the first rotation axis R1 and the third rotation axis R3, the distance between the first rotation axis R1 and the second rotation axis R2 may be changed.

According to an embodiment, as mentioned above, in the unfolded state, the first rotation plate 323 and the second rotation plate 325 are arranged to form a flat shape. In the folded state, the first rotation plate 323 and the second rotation plate 325 may be arranged at an angle relative to each other to the extent that the gap between the first rotation axis R1 and the third rotation axis R3 is reduced. For example, in the folded state, the first rotation plate 323 and the second rotation plate 325 may be accommodated further inward within the first housing 310 (or the second housing 320) than in the unfolded state. According to an embodiment, as the first rotation plate 323 and the second rotation plate 325 are accommodated further inward within the first housing 310 (or the second housing 320) in the folded state, the space for accommodating the folding area 243 transformed into a curved shape may be expanded. For example, according to the embodiment(s) of the disclosure, the space for accommodating the folding area 243 in the folded state is expanded, thereby suppressing the curvature of the folding area 243 from increasing. As mentioned above, as the curvature of the folding area 243 increases, peeling between some layers in the display 340 or permanent deformation may occur due to a deviation in tensile or compressive force. According to the embodiment(s) of the disclosure, damage to the display 340 caused by the folding or unfolding operation may be suppressed or alleviated by suppressing the increase in the curvature of the folding area 243.

According to an embodiment, by expanding the space accommodating the folding area 243 by the structure of the first rotating plate 323 and the second rotating plate 325, miniaturization of the electronic device 300 may be facilitated. For example, when the space accommodating the folding area 243 has a non-expandable structure, it may be inevitable to ensure a sufficient gap between the first housing 310 and the second housing 320 in order to reduce the curvature of the folding area 243 in the folded state. On the other hand, in the electronic device 300 according to the embodiment(s) of the disclosure, since the space for accommodating the folding area 243 in the folded state is expandable, reduction of the gap between the first housing 310 and the second housing 320 may be facilitated in the folded state. As a result, the electronic device 300 according to the embodiment(s) of the disclosure may be miniaturized while suppressing damage to the display 340 due to the folding or unfolding operation.

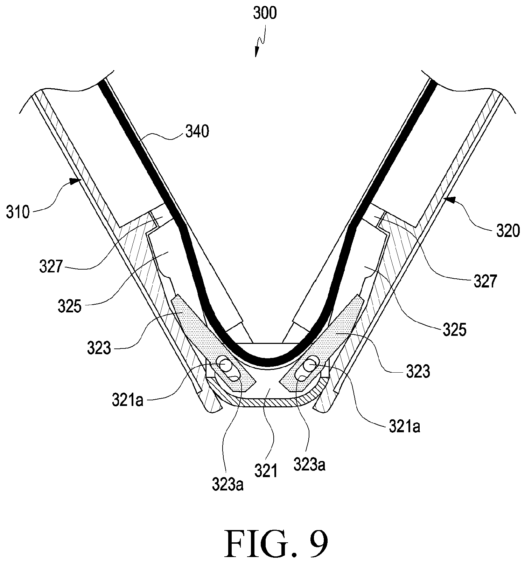

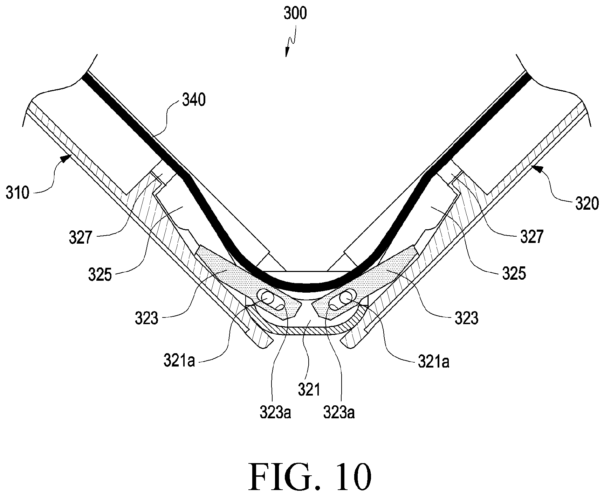

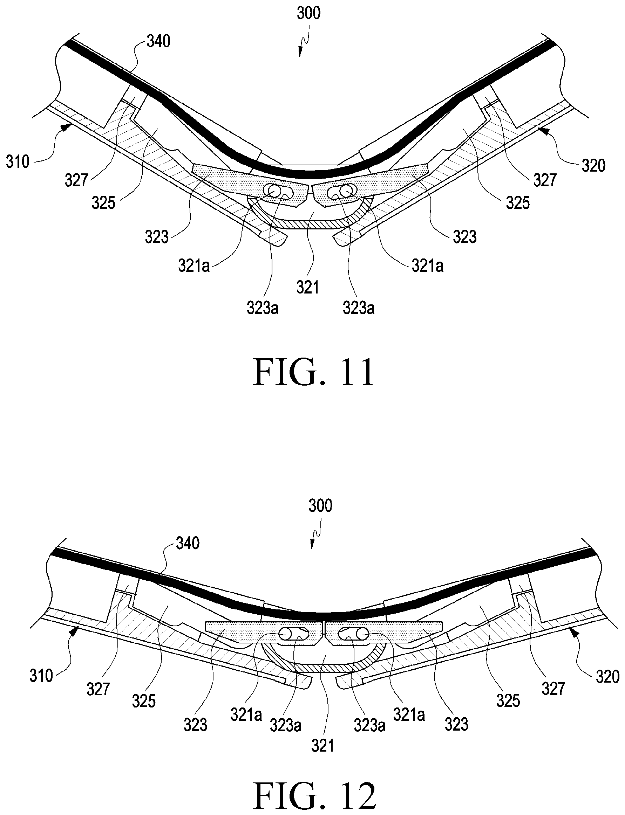

FIGS. 9 to 12 are views sequentially illustrating the unfolding operation of the electronic device according to an embodiment of the disclosure.

Referring to FIGS. 9 to 12, in response to the rotation of the first housing 310 and/or the second housing 320 from the folded state to the unfolded state, the first rotation plate 323 and the second rotation plate 325 may be aligned to gradually form a flat shape while rotating relative to each other. As mentioned above, the gap between the first rotation axis R1 and the third rotation axis R3, and/or the gap between the first rotation axis R1 and the second rotation axis R2 may change in response to the rotation of the first housing 310 and/or the second housing 320. For example, the gap between the first rotation axis R1 and the second rotation axis R2 may change in response to the rotation of the first housing 310 and/or the second housing 320, and the first rotation plate 323 may slide while rotating relative to the hinge module 321 or the guide protrusion 321a in response to the change in the gap between the first rotation axis R1 and the second rotation axis R2. In the unfolding motion, the first rotation plate 323 and the second rotation plate 325 may be arranged to gradually form a flat shape by rotating relative to each other in a direction in which the angle of inclination relative to each other increases.

According to an embodiment, in the unfolding motion (or folding motion), the movement angle range of the second rotation axis R2 relative to the first folding axis R1 may be less than 90 degrees, and the movement angle range of the third rotation axis R3 relative to the first folding axis A1 may be greater than 90 degrees. This may be implemented by the first rotation plate 323 being rotatably coupled to the second rotation plate 325 via the rail structure (e.g., the guide rail 325a and the rail groove 323b in FIG. 5) and sliding relative to the guide protrusion 321a (or the hinge module 321). According to an embodiment, when the second rotation axis R2 and the third rotation axis R3 are arranged at different heights from the first folding axis A1 and are disposed at different distances from the first folding axis A1 in the Z-axis direction in the unfolded state, the movement angle ranges of the second rotation axis R2 and the third rotation axis R3 may be different from each other. By configuring the movement angle range of the second rotation axis R2 to be smaller than the movement angle range of the third rotation axis R3, the first rotation plate 323 and the second rotation plate 325 may be accommodated inside the first housing 310 (or the second housing 320) in a state inclined relative to each other in the folded state, and may be arranged to form a flat shape in the unfolded state. For example, the first rotation plate 323 and the second rotation plate 325 may expand the space for accommodating the folding area 243 in the folded state, and/or may be arranged in a flat shape in the unfolded state to support the folding area 243.

According to an embodiment, the distance deviation between the first rotation axis R1 and the third rotation axis R3 in the folded state and the unfolded state may be allowed by the sliding movement of the first rotation plate 323 relative to the guide protrusion 321a and/or the rotation or inclination angle of the first rotation plate 323 and the second rotation plate 325. In an embodiment, the distance deviation between the first rotation axis R1 and the third rotation axis R3 in the folded state and the unfolded state may be allowed by the rotation or inclination angle of the first rotation plate 323 and the second rotation plate 325, and the first rotation plate 323 may rotate about the first rotation axis R1 without sliding relative to the guide protrusion 321a. For example, according to an embodiment, the sliding of the first rotation plate 323 relative to the guide protrusion 321a may not be allowed, and the distance deviation between the first rotation axis R1 and the third rotation axis R3 in the folded state and the unfolded state may be implemented by the rotation or inclination angle of the first rotation plate 323 and the second rotation plate 325.

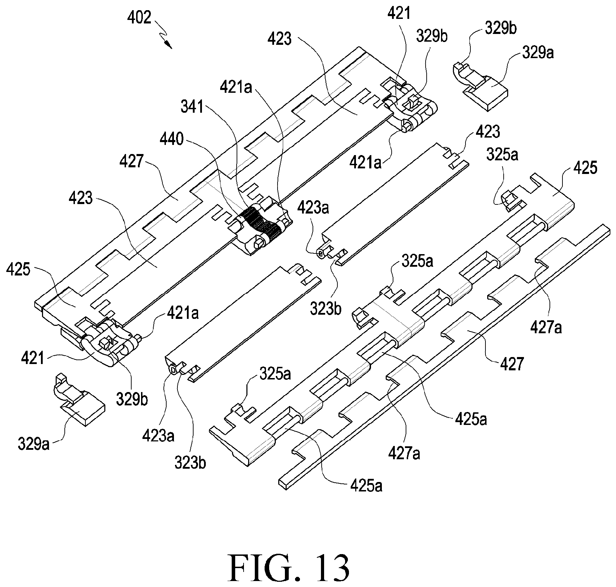

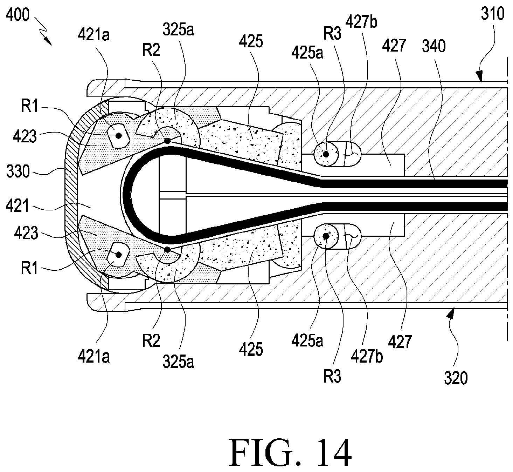

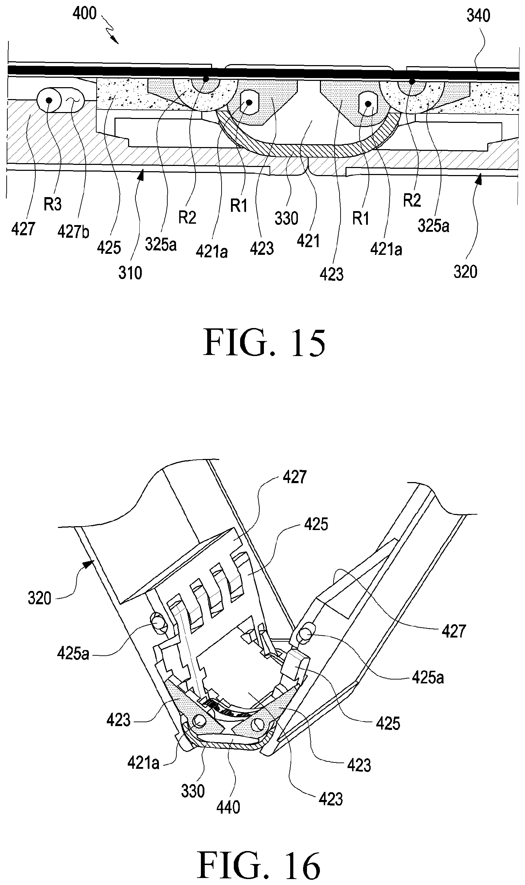

FIG. 13 is an exploded perspective view illustrating a hinge assembly of an electronic device according to an embodiment of the disclosure. FIG. 14 is a view illustrating the electronic device according to an embodiment of the disclosure in the folded state. FIG. 15 is a view illustrating the electronic device according to an embodiment of the disclosure in the unfolded state. FIG. 16 is a view illustrating the hinge assembly of the electronic device according to an embodiment of the disclosure.

The hinge assembly 402 of FIGS. 13 to 16 may differ from the hinge assembly 302 of FIG. 5 in that the slide structure of the guide protrusion 321a and the first rotation plate 323 is implemented between a second rotation plate 425 and a rotation support plate 427 of FIG. 13. According to an embodiment, the hinge assembly 402 of FIGS. 13 to 16 may differ from the hinge assembly 302 of FIG. 5 in that the multiple gears 341 are separated from a hinge module 421 of FIG. 13 and implemented as a separate gear module 440. In the hinge assembly 402 of FIGS. 13 to 16, the gear module 440 may be disposed between a pair of hinge modules 421, and a pair of first rotation plates 423 may be provided to correspond to the first housing (e.g., the first housing 310 in FIG. 4) or the second housing (e.g., the second housing 320 in FIG. 4). In describing the embodiment of FIGS. 13 to 16, for the components that may be easily understood through the preceding embodiments, the same reference numbers in the drawings may be assigned or omitted, and detailed descriptions thereof may also be omitted.

Referring to FIGS. 13 to 16, the hinge assembly 402 (e.g., the hinge module 202 in FIG. 3 or the hinge assembly 302 in FIG. 5) may include a pair of first rotation plates 423, one or more second rotation plates 425, and/or a rotation support plate 427 corresponding to the hinge modules 421, the gear module 440, and the first housing 310 (or the second housing 320). In an embodiment, the hinge modules 421 and the gear module 440 may be arranged along the direction of a folding axis (e.g., the folding axis A in FIG. 1 or the first folding axis A1 and the second folding axis A2 in FIG. 6), and the hinge modules 421 may rotatably connect the first housing 310 and the second housing 320 by including hinge arms 329a. In an embodiment, since the multiple gears 341 are connected to the first rotation plates 423, when one of the first housing 310 and the second housing 320 rotates, the other may be rotated. Regarding the number and arrangement of the multiple gears 341, it has been previously described that they are configured to rotate the first housing 310 and the second housing 320 in the opposite directions relative to each other.

According to an embodiment, the hinge assembly 402 may include a rotation support protrusion 421a disposed on one or more hinge modules 421 and/or the gear module 440, and a rotation support hole 423a provided in one or more first rotation plates 423. For example, the one or more first rotation plates 423 may be arranged to be rotatable about the first rotation axes R1 between one of the hinge modules 421 and the gear module 440 in the state in which the rotation support protrusion 421a are accommodated in the rotation support hole 423a. For example, the rotation support protrusion 421a and the rotation support hole 423a may substantially protrude or extend in the direction of the first rotation axes R1 and may rotatably couple the one or more first rotation plates 423 to the hinge module 421 and/or the gear module 440. In coupling the one or more first rotation plates 423 and the one or more second rotation plates 425, the hinge assembly 402 may include a guide rail 325a and a rail groove 323b that provide a second rotation axis R2, which may be similar to the preceding embodiments, and thus a detailed description thereof will be omitted.

According to an embodiment, the hinge assembly 402 may include a guide rod 425a (or guide protrusion) formed on one of the second rotation plate 425 and the rotation support plate 427, and a second guide groove 427a formed on the other of the second rotation plate 425 and the rotation support plate 427. The guide rod 425a may provide, for example, a third rotation axis R3, and may be substantially slidably accommodated in the second guide groove 427a. For example, the second guide groove 427a may extend in a direction intersecting the first folding axis A1 or the third rotation axis R3. In an embodiment, the second guide groove 427a is formed on one surface of the rotation support plate 427 in a recess shape, allowing the guide rod 425a to be easily removed from the second guide groove 427a (or the rotation support plate 427). For example, when the rotation support plate 427 is coupled to the first housing 310 or the second housing 320, the guide rod 425a may be substantially restrained on the rotation support plate 427 and the first housing 310 (or the rotation support plate 427 and the second housing 320) in a rotationally or slidably movable state. In an embodiment, a groove formed in the first housing 310 or the second housing 320 may be combined with the second guide groove 427a to form a hole (e.g., the hole 427b in FIG. 14) that accommodates the guide rod 425a. The sliding motion of the guide rod 425a may be similar to the motion of the guide protrusion 321a moving within the guide groove 323a of FIG. 5.

According to an embodiment, in the unfolded state, the first rotation plate 423 and the second rotation plate 425 may support at least a portion of the folding area 243 by a support structure provided by the hinge cover 330, a fastening structure of the rotation support protrusion 421a and the rotation support hole 423a, a fastening structure of the guide rail 325a and the rail groove 323b, and/or a fastening structure of the guide rod 425a and the second guide groove 427a. When the hinge module 421 includes a curved area (e.g., the curved area 321b in FIG. 6), the hinge assembly 402 and/or the hinge module 421 may further include the one or more support protrusions 329b that protrude or retract on the curved area 321b. The support protrusions 329b may protrude from the curved area 321b in the unfolded state to support the folding area 243. In the unfolded state, the first rotation plate 423 may be supported by the hinge cover 330 to maintain the state of being arranged to form a flat shape with the second rotation plate 425, which may be similar to the preceding embodiments.

According to an embodiment, in the folded state, the first rotation plate 423 and the second rotation plate 425 may be accommodated more inward within the first housing 310 or the second housing 320 than in the unfolded state, in an inclined state (e.g., at an angle less than 180 degrees) relative to each other. For example, the folding area 243 transformed into a curved shape in the folded state may be accommodated in a space surrounded by the first rotation plate 423 and the second rotation plate 425 and/or a space surrounded by the curved area 321b of the hinge module 421, thereby suppressing or alleviating an increase in the curvature of the folding area 243.

An electronic device (e.g., the electronic device 200 or 300 in FIGS. 1 to 4) according to an embodiment of the disclosure may be transformed between the folded state and the unfolded state by including a hinge assembly (e.g., the hinge module 202 in FIG. 3, or the hinge assembly 302 or 402 in FIG. 4, FIG. 5, and/or FIG. 13). In the unfolded state of the electronic device, the first rotation plate (e.g., the first rotation plate 323 or 423 of FIG. 5 and/or FIG. 13) and the second rotation plate (e.g., the second rotation plate 325 or 425 in FIG. 5 and/or FIG. 13) may be arranged to form a flat shape and support a folding area (e.g., the folding area 243 in FIG. 1 or FIG. 3) of the flexible display (e.g., the display 240 or 340 in FIG. 3 or FIG. 4), thereby providing a stable use environment. In the folded state of the electronic device, the first rotation plate and the second rotation plate may be arranged at an angle relative to each other to provide a space for accommodating the folding area transformed into a curved shape. For example, in the folded state, the folding area may maintain a state with a sufficient radius of curvature, thereby alleviating the deviation of tensile force or compressive force caused by shape transformation. According to an embodiment, by alleviating the tensile force or compressive force caused by the shape transformation, the layers of the flexible display can be suppressed from being peeled or permanently deformed. For example, even if the electronic device is miniaturized, damage to the flexible display caused by peeling or permanent deformation may be suppressed or alleviated.

The effects that are capable of being obtained by the disclosure are not limited to those described above, and other effects not described above may be clearly understood by a person ordinarily skilled in the art to which the disclosure belongs based on the following description.

As described above, according to an embodiment of the disclosure, an electronic device (e.g., the electronic device 200 or 300 in FIGS. 1 to 4) may include a first housing (e.g., the first housing 210 or 310 in FIGS. 1 to 4), a second housing (e.g., the second housing 220 or 320 in FIGS. 1 to 4) configured to rotate relative to the first housing about at least one folding axis (e.g., the folding axis A in FIG. 1 or the first folding axis A1 and the second folding axis A2 in FIG. 5) between a position facing the first housing (hereinafter, a "folded state") and a position unfolded by a predetermined angle from the folded state (hereinafter, an "unfolded state"), a hinge assembly (e.g., the hinge module 202 in FIG. 3, or the hinge assembly 302 or 402 in FIG. 4, FIG. 5, and/or FIG. 13), a flexible display (e.g., the display 240 or 340 in FIG. 1, FIG. 3, or FIG. 4) including a first display area (e.g., the first display area 241 in FIG. 1 or FIG. 3) disposed on one side of the first housing, a second display area (e.g., the second display area 242 in FIG. 1 or FIG. 3) disposed on one surface of the second housing, and a folding area (e.g., the folding area 243 in FIG. 1 or FIG. 3) connecting the first display area and the second display area and disposed to correspond to at least a portion of the hinge assembly, and a hinge cover (e.g., the hinge cover 230 or 330 in FIG. 2, FIG. 3, or FIG. 4) arranged between the first housing and the second housing and configured to be concealed or exposed between the other surface of the first housing and the other surface of the second housing as the second housing rotates. In an embodiment, the hinge assembly may include a hinge module (e.g., the hinge module 321 or 421 or the gear module 440 of FIG. 4, FIG. 5 and/or FIG. 13) disposed inside the hinge cover and providing at least one folding axis, a first rotation plate (e.g., the first rotation plate 323 or 423 in FIG. 5 or FIG. 13) rotatably coupled to the hinge module and configured to rotate about a first rotation axis (e.g., the first rotation axis R1 in FIG. 6, FIG. 7, FIG. 14, and/or FIG. 15), a second rotation plate (e.g., the second rotation plate 325 or 425 in FIG. 5 or FIG. 13) rotatably coupled to the first rotation plate at a position spaced apart from the first rotation axis and configured to rotate about a second rotation axis (e.g., the second rotation axis R2 in FIG. 6, FIG. 7, FIG. 14, and/or FIG. 15), and a rotation support plate (e.g., the rotation support plate 327 or 427 in FIG. 5 or FIG. 13) fixed to the first housing or the second housing. The rotation support plate supports the second rotation plate to be rotatably coupled at a position spaced apart from the second rotation axis and to rotate about a third rotation axis (e.g., the third rotation axis R3 in FIG. 6, FIG. 7, FIG. 14, and/or FIG. 15). In an embodiment, in the unfolded state, the first rotation plate may be configured to support at least a portion of the folding area by being supported by the hinge cover to be arranged to form a plane with the second rotation plate. In an embodiment, as the second housing rotates from the unfolded state to the folded state, the distance between the first rotation axis and the third rotation axis may be configured to decrease.

According to an embodiment, the first rotation plate and the second rotation plate may be configured to rotate relative to each other about the second rotation axis, so that in the folded state, the first and second rotation plates are arranged at an angle relative to each other and accommodated further inwardly into the first housing or the second housing than in the unfolded state.

According to an embodiment, in the folded state, the folding area may be disposed to form a curved surface within a space at least partially surrounded by the first rotation plate and the second rotation plate.

According to an embodiment, the hinge assembly may further include a guide protrusion extending from the hinge module along the at least one folding axis direction to provide the first rotation axis (e.g., the guide protrusion 323a in FIG. 5 or the rotation support protrusion 423a in FIG. 14), and a guide groove formed on the first rotation plate and extending along a direction intersecting the at least one folding axis and configured to accommodate the guide protrusion (e.g., the guide groove 323a in FIG. 3). In an embodiment, the first rotation plate may be supported by the guide protrusion to rotate about the first rotation axis, and may be configured to slide relative to the guide protrusion under the guidance of the guide groove.

According to an embodiment, the hinge assembly may further include a guide protrusion or a guide rod (e.g., the guide rod 425a in FIG. 13) formed on the second rotation plate and extending along the at least one folding axis direction to provide the third rotation axis, and a guide groove (e.g., the second guide groove 427a in FIG. 13) formed on the rotation support plate and extending along a direction intersecting the at least one folding axis and configured to accommodate the guide protrusion or the guide rod. In an embodiment, the second rotation plate may be configured to rotate about the guide protrusion or the guide rod and to slide relative to the rotation support plate under the guidance of the guide groove.

According to an embodiment, the hinge assembly may include a guide rail (e.g., the guide rail 325a in FIG. 5 or FIG. 13) disposed on one of the first rotation plate or the second rotation plate and extending along an arc trajectory centered on the second rotation axis, and a rail groove (e.g., the rail groove 323b in FIG. 5 or FIG. 13) disposed on the other of the first rotation plate or the second rotation plate and extending along the arc trajectory centered on the second rotation axis to accommodate the guide rail. In an embodiment, the guide rail may be configured to move along the arc trajectory within the rail groove.

According to an embodiment, the hinge assembly may further include a hinge arm (e.g., the hinge arm 329a in FIG. 5 or FIG. 13) coupled to the hinge module and configured to rotate about the at least one folding axis and mounted on either the first housing or the second housing.

According to an embodiment, the hinge assembly may further include a curved area (e.g., the curved area 321b in FIG. 6) disposed to face the folding region as a portion of the hinge module. In an embodiment, in the folded state, the folding area may be disposed to form a curve in a space at least partially surrounded by the curved area.

According to an embodiment, the hinge assembly may further include a support protrusion (e.g., the support protrusion 329b in FIG. 5 or FIG. 13) provided on the hinge arm and accommodated inside the hinge module. In an embodiment, in the unfolded state, the support protrusion may be configured to protrude from the hinge module at a position corresponding to the folding area.

According to an embodiment, the support protrusion may be configured to protrude or retract on the curved area as the second housing rotates.

According to an embodiment, the hinge assembly may include a first hinge arm coupled to the hinge module and configured to rotate about a first folding axis of the at least one folding axis, and mounted on the first housing, a second hinge arm coupled to the hinge module and configured to rotate about a second folding axis of the at least one folding axis, and mounted on the second housing, and multiple gears (e.g., the gear 341 in FIG. 5 or FIG. 13) disposed between the first folding axis and the second folding axis. In an embodiment, the multiple gears may be configured to rotate the first hinge arm and the second hinge arm in opposite directions relative to each other.

According to an embodiment of the disclosure, an electronic device (e.g., the electronic device 200 or 300 in FIGS. 1 to 4) may include a housing (e.g., the housing 201 in FIG. 3) including a first housing (e.g., the first housing 210 or 310 in FIGS. 1 to 4) and a second housing (e.g., the second housing 220 or 320 in FIGS. 1 to 4) rotatably coupled to each other about one or more folding axes (e.g., the folding axis A in FIG. 1 or the first folding axis A1 and the second folding axis A2 in FIG. 5) between a position facing each other (hereinafter, a "folded state") and a position unfolded by a predetermined angle (hereinafter, an "unfolded state"), a hinge assembly (e.g., the hinge module 202 in FIG. 3 or a hinge assembly 302 or 402 in FIG. 4, FIG. 5, and/or FIG. 13) that is at least partially disposed between the first housing and the second housing and rotatably connects the first housing and the second housing, a flexible display (e.g., the display 240 or 340 in FIG. 1, FIG. 3, or FIG. 4) including a first display area (e.g., the first display area 241 in FIG. 1 or FIG. 3) disposed on one surface of the first housing, a second display area (e.g., the second display area 242 in FIG. 1 or FIG. 3) disposed on one surface of the second housing, and a folding area (e.g., the folding area 243 in FIG. 1 or FIG. 3) connecting the first display area and the second display area and disposed to correspond to at least a portion of the hinge assembly, and a hinge cover (e.g., the hinge cover 230 or 330 in FIG. 2, FIG. 3, or FIG. 4) disposed between the first housing and the second housing and configured to be concealed or exposed between the other surface of the first housing and the other surface of the second housing as the second housing rotates. In an embodiment, the hinge assembly may include a hinge module (e.g., the hinge module 321 or 421 or the gear module 440 of FIG. 4, FIG. 5 and/or FIG. 13) disposed inside the hinge cover and providing at least one folding axis, at least one first rotation plate (e.g., the first rotation plate 323 or 423 in FIG. 5 or FIG. 13) rotatably coupled to the hinge module and configured to rotate about a first rotation axis (e.g., the first rotation axis R1 in FIG. 6, FIG. 7, FIG. 14, and/or FIG. 15), at least one second rotation plate (e.g., the second rotation plate 325 or 425 in FIG. 5 or FIG. 13) rotatably coupled to the first rotation plate at a position spaced apart from the first rotation axis and configured to rotate about a second rotation axis (e.g., the second rotation axis R2 in FIG. 6, FIG. 7, FIG. 14, and/or FIG. 15), and a rotation support plate (e.g., the rotation support plate 327 or 427 in FIG. 5 or FIG. 13) fixed to the first housing or the second housing. The rotation support plate supports the second rotation plate to be rotatably coupled at a position spaced apart from the second rotation axis and to rotate about a third rotation axis (e.g., the third rotation axis R3 in FIG. 6, FIG. 7, FIG. 14, and/or FIG. 15). In an embodiment, in the unfolded state, the first rotation plate may be configured to support at least a portion of the folding area by being supported by the hinge cover to be arranged to form a plane with the second rotation plate. In an embodiment, the first rotation plate and the second rotation plate may be configured to rotate relative to each other about the second rotation axis, so that in the folded state, the first and second rotation plates are arranged at an angle relative to each other and accommodated further inwardly into the first housing or the second housing than in the unfolded state.

According to an embodiment, in the folded state, the folding area may be disposed to form a curved surface within a space at least partially surrounded by the first rotation plate and the second rotation plate.

According to an embodiment, the hinge assembly may further include a guide protrusion extending from the hinge module along the at least one folding axis direction to provide the first rotation axis (e.g., the guide protrusion 323a in FIG. 5 or the rotation support protrusion 423a in FIG. 14), and a guide groove (e.g., the guide groove 323a in FIG. 3) formed on the first rotation plate and extending along a direction intersecting the at least one folding axis and configured to accommodate the guide protrusion. In an embodiment, the first rotation plate may be supported by the guide protrusion to rotate about the first rotation axis, and may be configured to slide relative to the guide protrusion under the guidance of the guide groove.

According to an embodiment, the hinge assembly may further include a guide protrusion or a guide rod (e.g., the guide rod 425a in FIG. 13) formed on the second rotation plate and extending along the at least one folding axis direction to provide the third rotation axis, and a guide groove (e.g., the second guide groove 427a in FIG. 13) formed on the rotation support plate and extending along a direction intersecting the at least one folding axis and configured to accommodate the guide protrusion or the guide rod. In an embodiment, the second rotation plate may be configured to rotate about the guide protrusion or the guide rod and to slide relative to the rotation support plate under the guidance of the guide groove.

According to an embodiment, the hinge assembly may include a guide rail (e.g., the guide rail 325a in FIG. 5 or FIG. 13) disposed on one of the first rotation plate or the second rotation plate and extending along an arc trajectory centered on the second rotation axis, and a rail groove (e.g., the rail groove 323b in FIG. 5 or FIG. 13) disposed on the other of the first rotation plate or the second rotation plate and extending along the arc trajectory centered on the second rotation axis to accommodate the guide rail. In an embodiment, the guide rail may be configured to move along the arc trajectory within the rail groove.

According to an embodiment, the hinge assembly may further include a hinge arm (e.g., the hinge arm 329a in FIG. 5 or FIG. 13) coupled to the hinge module and configured to rotate about the at least one folding axis and mounted on either the first housing or the second housing.

According to an embodiment, the hinge assembly may further include a curved area (e.g., the curved area 321b in FIG. 6) disposed to face the folding region as a portion of the hinge module. In an embodiment, in the folded state, the folding area may be disposed to form a curve in a space at least partially surrounded by the curved area.

According to an embodiment, the hinge assembly may further include a support protrusion (e.g., the support protrusion 329b in FIG. 5 or FIG. 13) provided on the hinge arm and accommodated inside the hinge module. In an embodiment, in the unfolded state, the support protrusion may be configured to protrude from the curved area.

According to an embodiment, the hinge assembly may include a first hinge arm coupled to the hinge module and configured to rotate about a first folding axis of the at least one folding axis, and mounted on the first housing, a second hinge arm coupled to the hinge module and configured to rotate about a second folding axis of the at least one folding axis, and mounted on the second housing, and multiple gears (e.g., the gear 341 in FIG. 5 or FIG. 13) disposed between the first folding axis and the second folding axis. In an embodiment, the multiple gears may be configured to rotate the first hinge arm and the second hinge arm in opposite directions relative to each other.

Although an embodiment of the disclosure has been illustrated and described, it should be appreciated that the embodiment is not intended to limit the disclosure, but is provided for the sake of illustration. It will be apparent to those skilled in the art that various changes may be made to the form and details of the disclosure without departing from the overall perspective of the disclosure including the appended claims and equivalents thereof.

## Claims

1. An electronic device (200; 300) comprising:
a first housing (210; 310);
a second housing (220; 320) configured to rotate about at least one folding axis (A; A1, A2) relative to the first housing between a position facing the first housing (hereinafter, "folded state") and a position unfolded by a predetermined angle from the folded state (hereinafter, "unfolded state");
a hinge assembly (202; 302; 402) that is at least partially arranged between the first housing and the second housing and rotatably connects the first housing and the second housing;
a flexible display (240; 340) comprising a first display area (241) disposed on one surface of the first housing, a second display area (242) disposed on one surface of the second housing, and a folding area (243) that connects the first display area and the second display area and is disposed to correspond to at least a portion of the hinge assembly; and
a hinge cover (230; 330) arranged between the first housing and the second housing and configured to be concealed or exposed between another surface of the first housing and another surface of the second housing as the second housing rotates,
wherein the hinge assembly comprises:
a hinge module (321; 421, 440) disposed inside the hinge cover and configured to provide the at least one folding axis,
a first rotation plate (323; 423) rotatably coupled to the hinge module and configured to rotate about a first rotation axis (R1),
a second rotation plate (325; 425) rotatably coupled to the first rotation plate at a position spaced apart from the first rotation axis and configured to rotate about a second rotation axis (R2), and
a rotation support plate (327; 427) fixed to the first housing or the second housing, wherein the rotation support plate supports the second rotation plate to be rotatably coupled at a position spaced apart from the second rotation axis and to rotate about a third rotation axis (R3),
wherein, in the unfolded state, the first rotation plate is configured to support at least a portion of the folding area by being supported by the hinge cover to be arranged to form a plane with the second rotation plate, and
wherein, as the second housing rotates from the unfolded state to the folded state, a distance between the first rotation axis and the third rotation axis is configured to decrease.

2. The electronic device of claim 1, wherein the first rotation plate and the second rotation plate are configured to rotate relative to each other about the second rotation axis, so that in the folded state, the first and second rotation plates are arranged at an angle relative to each other and accommodated further inwardly into the first housing or the second housing than in the unfolded state.

3. The electronic device of claim 2, wherein, in the folded state, the folding area is disposed to form a curved surface within a space at least partially surrounded by the first rotation plate and the second rotation plate.

4. The electronic device according to any one of claims 1 to 3, wherein the hinge assembly further comprises:
a guide protrusion (321a; 421a) extending from the hinge module along the at least one folding axis direction to provide the first rotation axis; and
a guide groove (323a; 423a) formed on the first rotation plate and extending along a direction intersecting the at least one folding axis and configured to accommodate the guide protrusion, and
wherein the first rotation plate is supported by the guide protrusion to rotate about the first rotation axis, and is configured to slide relative to the guide protrusion under the guidance of the guide groove.

5. The electronic device according to any one of claims 1 to 4, wherein the hinge assembly further comprises:
a guide protrusion or a guide rod (427a) formed on the second rotation plate and extending along the at least one folding axis direction to provide the third rotation axis; and
a guide groove (427a) formed on the rotation support plate and extending along a direction intersecting the at least one folding axis and configured to accommodate the guide protrusion or the guide rod,
wherein the second rotation plate is configured to rotate about the guide protrusion or the guide rod and to slide relative to the rotation support plate under the guidance of the guide groove.

6. The electronic device according to any one of claims 1 to 5, wherein the hinge assembly comprises:
a guide rail (325a) disposed on one of the first rotation plate or the second rotation plate and extending along an arc trajectory centered on the second rotation axis; and
a rail groove (323b) disposed on another one of the first rotation plate or the second rotation plate and extending along the arc trajectory centered on the second rotation axis to accommodate the guide rail, and
wherein the guide rail is configured to move along the arc trajectory within the rail groove.

7. The electronic device according to any one of claims 1 to 6, wherein the hinge assembly further comprises a hinge arm (329a) coupled to the hinge module and configured to rotate about the at least one axis and mounted on either the first housing or the second housing.

8. The electronic device of claim 7, wherein the hinge assembly further comprises a curved area (321b) disposed to face the folding area as a portion of the hinge module, and
wherein, in the folded state, the folding area is disposed to form a curve in a space at least partially surrounded by the curved area.

9. The electronic device of claim 8, wherein the hinge assembly further comprises a support protrusion (329b) provided on the hinge arm and accommodated inside the hinge module, and
wherein, in the unfolded state, the support protrusion is configured to protrude from the hinge module at a position corresponding to the folding area.

10. The electronic device of claim 9, wherein the support protrusion is configured to protrude or retract on the curved area as the second housing rotates.

11. The electronic device of any one of claims 1 to 10, wherein the hinge assembly comprises:
a first hinge arm coupled to the hinge module and configured to rotate about a first folding axis of the at least one folding axis, and mounted on the first housing;
a second hinge arm coupled to the hinge module and configured to rotate about a second folding axis of the at least one folding axis, and mounted on the second housing; and
multiple gears arranged between the first folding axis and the second folding axis,
wherein the multiple gears are configured to rotate the first hinge arm and the second hinge arm in opposite directions relative to each other.

12. An electronic device (200; 300) comprising:
a housing (201) comprising a first housing (210; 310) and a second housing (220; 320) that are coupled to each other to be rotatable about one or more folding axes (A; A1, A2) between a position facing each other (hereinafter, a "folded state") and a position unfolded by a predetermined angle (hereinafter, an "unfolded state");
a hinge assembly (202; 302; 402) that is at least partially arranged between the first housing and the second housing and rotatably connects the first housing and the second housing;
a flexible display comprising a first display area (241) disposed on one surface of the first housing, a second display area (242) disposed on one surface of the second housing, and a folding area (243) that connects the first display area and the second display area and is disposed to correspond to at least a portion of the hinge assembly; and
a hinge cover (230; 330) arranged between the first housing and the second housing and configured to be concealed or exposed between another surface of the first housing and another surface of the second housing as the second housing rotates,
wherein the hinge assembly comprises:
a hinge module (321; 421, 440) disposed inside the hinge cover and configured to provide one or more folding axes,
at least one first rotation plate (323; 423) rotatably coupled to the hinge module and configured to rotate about a first rotation axis (R1),
at least one second rotation plate (325; 425) rotatably coupled to the first rotation plate at a position spaced apart from the first rotation axis and configured to rotate about a second rotation axis (R2), and
a rotation support plate (327; 427) fixed to the first housing or the second housing, wherein the rotation support plate supports the second rotation plate to be rotatably coupled at a position spaced apart from the second rotation axis and to rotate about a third rotation axis (R3),
wherein, in the unfolded state, the first rotation plate is configured to support at least a portion of the folding area by being supported by the hinge cover to be arranged to form a plane with the second rotation plate, and
the first rotation plate and the second rotation plate are configured to rotate relative to each other about the second rotation axis, so that in the folded state, the first and second rotation plates are arranged at an angle relative to each other and accommodated further inwardly into the first housing or the second housing than in the unfolded state.

13. The electronic device of claim 12, wherein, in the folded state, the folding area is disposed to form a curved surface within a space at least partially surrounded by the first rotation plate and the second rotation plate.

14. The electronic device according to any one of claims 12 and 13, wherein the hinge assembly further comprises:
a guide protrusion (321a; 421a) extending from the hinge module along a direction of the at least one folding axis to provide the first rotation axis; and
a guide groove (323a) formed on the first rotation plate and extending along a direction intersecting the direction of the one or more folding axes and configured to accommodate the guide protrusion, and
wherein the first rotation plate is supported by the guide protrusion to rotate about the first rotation axis, and is configured to slide relative to the guide protrusion under the guidance of the guide groove.

15. The electronic device according to any one of claims 12 to 14, wherein the hinge assembly further comprises:
a guide protrusion or a guide rod (425a) formed on the second rotation plate and extending along the direction of the one or more folding axes to provide the third rotation axis; and
a guide groove (427a) formed on the rotation support plate and extending along a direction intersecting the one or more folding axes and configured to accommodate the guide protrusion or the guide rod,
wherein the second rotation plate is configured to rotate about the guide protrusion or the guide rod and to slide relative to the rotation support plate under the guidance of the guide groove.
